# EUROPEAN PATENT SPECIFICATION

(11) **EP 0 400 853 B1**
(45) Date of publication and mention of the grant of the patent: **14.06.1995**
(21) Application number: 90305474.0
(22) Date of filing: 21.05.1990
(51) Int. Cl.: G01R 27/04, G01B 15/02, G01R 31/11

(54) **Contactless measurement of the electrical resistance per unit length of filaments**
Kontaktlose Messung des elektrischen Widerstandes pro Längeneinheit von fadenförmigen Elementen
Mesure sans contact de résistance électrique par une unité de section d'un filament

(30) Priority: 31.05.1989 GB 8912458
(43) Date of publication of application: 05.12.1990
(73) Proprietor: NORTHERN TELECOM LIMITED, Montreal, Quebec H2Y 3Y4 (CA)
(72) Inventor: Sapsford, Gary Stephen, Bishop's Stortford, Herts CM23 4DN (GB); Robinson, Alan, Harlow, Essex CM19 4DE (GB)
(74) Representative: Laurence, Simon French

(56) References cited:
- DE-A- 2 916 467
- GB-A- 2 052 760
- US-A- 2 746 015
- SOVIET INVENTIONS ILLUSTRATED, Derwent Publications Ltd., week 8509, abstract no. 054649, SO1, 10 April 85, & SU-A-1104 442

## Description

This invention relates to the measurement of the electrical resistance per unit length of a filament, and finds particular application in situations in which it is inconvenient or impossible to make direct electrical contact with the conductive filament. A particular example of an instance where direct electrical contact is either undesirable or impossible concerns making measurements of electrical resistance per unit length of electrically conductive coatings, for instance carbon coatings, applied to optical fibres. In this instance, direct contact with the coating may be undesirable for risk of damaging the strength of the fibre, or because the electrically conductive coating has already itself been coated with a dielectric protective coating, for instance, of plastics material.

During the manufacture of an optical fibre with a hermetic coating of carbon, it is desirable that the thickness of the carbon coating is monitored. One approach is to measure the conductance of the fibre, which, for thin coatings of conductivity σ, is proportional to the thickness t, wherein
conductance per$\text{unit length = 2πatσ (t << a)}$
where a is the fibre radius.

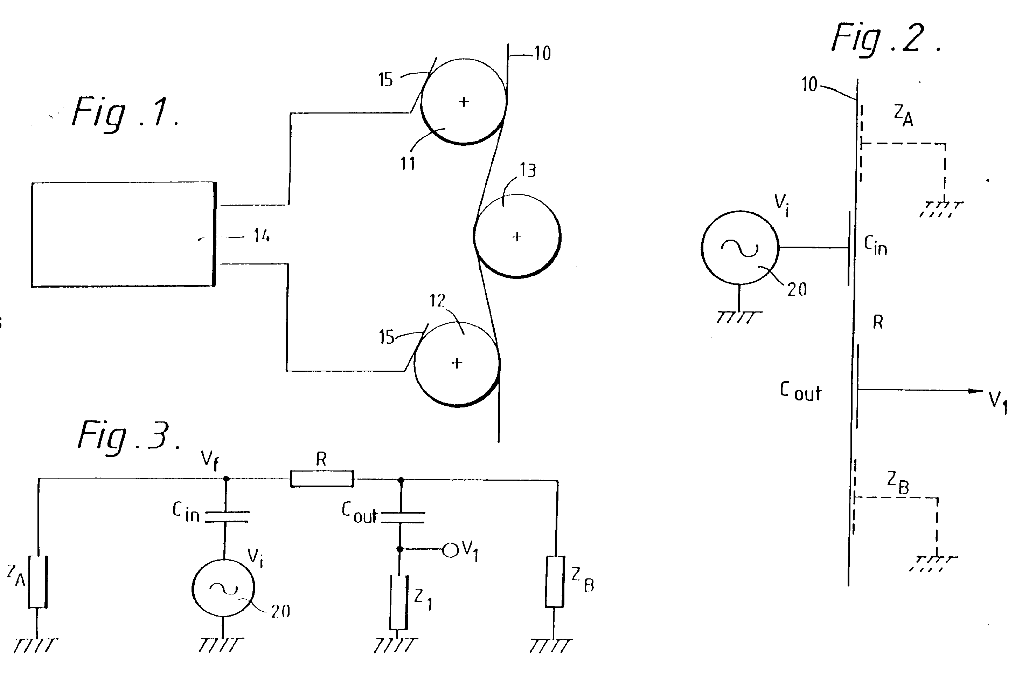

Figure 1 depicts how an existing design of tensometer can be adapted to enable the making of direct current on-line measurement of electrical resistance per unit length. In this tensometer, the optical fibre 10 passes over two guide wheels 11 and 12 between which the fibre is deflected by a resiliently biased tensometer wheel 13. The tensometer is adapted by replacing the original wheels 11 and 12 with graphite wheels, and by connecting a resistance meter 14 across the graphite wheels using sliding contacts 15. As indicated previously, the drawback of this approach is that the direct contact between the carbon coating and the tensometer wheels is liable to damage the coating and hence impair the strength of the fibre, whereas, if the carbon is provided with a plastics protective coating prior to passing through the tensometer, the presence of this protective coating prevents direct electrical contact between the carbon coating and the graphite wheels.

If instead of using direct current to make the measure, alternating current were to be used, then at least in principle, contactless capacitive coupling can replace the graphite wheels of Figure 1. However, in practice the fibre will also be susceptible to capactitive coupling with other parts of the fibre drawing equipment, as indicated schematically in Figure 2 and in the equivalent circuit diagram of Figure 3. In Figures 2 and 3, Z_{A} and Z_{B} are largely capacitive impedances, the product of interaction with the surrounding equipment of the fibre either side of the coupling capacitances Cᵢₙ and Cₒᵤₜ. Both the potential induced on the fibre, V_{f}, derived from an oscillator 20 providing an a.c. signal Vᵢ, and the fraction of V_{f} tapped out to give the output signal, V₁, depend on the magnitudes of the stray impedances Z_{A} and Z_{B}.

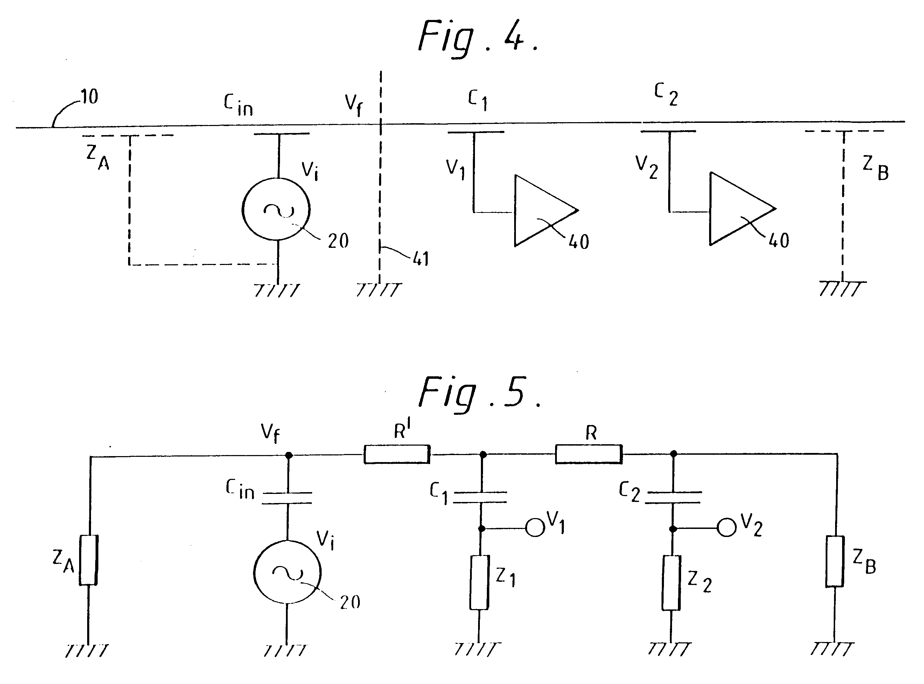

In order to calculate the fibre resistance R unambiguously, it is necessary either to know the stray impedances Z_{A} and Z_{B}, or to use multiple probes to derive both the potential on the fibre V_{f} and its rate of change. For this purpose, two capacitive taps, C₁ and C₂, respectively tapping off signals V₁ and V₂ fed to buffer amplifiers 40, may be employed as indicated in Figure 4. Some form of screening 41 between the oscillator and the taps will also be necessary to reduce direct capacitive coupling between the oscillator and the taps. The equivalent circuit is illustrated in Figure 5.

A different approach to the measurement of electrical resistance per unit length of a filament is described in SU-A-1104 442. The filament concerned in that instance is a high resistance microwire. The method described therein employs a superhigh frequency microwave structure comprising a cylindrical sleeve which contains coaxial circular diaphragms. Superhigh frequency microwave power is launched into one end of the structure, but at an operating wavelength significantly greater than the lower cut-off wavelength of the structure. When the high resistance microwire is coaxially inserted into the microwave structure, the below cut-off aspect of the system is disturbed, and operating wavelength energy can now propagate inside the structure, being attenuated by an amount which depends upon the resistance per unit length of the microwire in the superhigh frequency range.

The present invention is based upon measurements made upon a coaxial transmission line, and hence operates in a much lower frequency range, typically in the range from a few hundred kilohertz to about ten gigahertz.

According to the present invention there is provided a contactless method of measuring the electrical resistance per unit length of a filament, which filament is passed axially through an electrically conductive structure, wherein the method of measuring includes the measurement of a parameter functionally dependent upon a propagation constant of an alternating electrical signal injected onto a transmission path comprising the structure and the filament passing through it, characterised in that the electrically conductive structure consists of an electrically conductive tube divided into a plurality of electrically discrete sections co-operating with the filament to constitute a coaxial transmission line, and in that said alternating electrical signal is injected onto one of said sections.

The particular solution disclosed by the present invention to the problem of contactless measurement of the thickness of a coating of a material of known electrical resistivity upon an electrically insulating filament of known cross-section has some features in common with the solution disclosed in United Kingdom Patent Specification GB 2 052 760 A to an entirely different problem, namely the measurement of the moisture content of the flux coating present upon a length of welding rod. In both instances the solutions disclosed to the respective problems involve the creation of a coaxial transmission line, and the measurement of a propagation constant of that line. In other respects the respective solutions are, like the respective problems, radically different. The solution to the coating thickness measurement problem is not concerned with dielectric properties, but instead is in effect looking for the changes produced by substituting, for the inner conductor of a conventional construction of coaxial transmission line, a relatively high resistance conductor. In the former instance it is the introduction of significant additional parallel admittance per unit length into the transmission line that changes is propagation characteristics, whereas in the latter it is the introduction of significant additional series impedance. Consequent upon these differences, microwave frequencies in the region of 10 gigahertz are employed for the moisture measurement, whereas frequencies in the range of a few hundred kilohertz to about ten megahertz are typically appropriate for the coating thickness measurement.

Instead of analysing the signal appearing on the line at just one point spaced from where a signal is injected onto the line, it is generally preferred to effect a comparison between the signals appearing at two successive points on the line, and it is particularly preferred to use the result of the comparison in a feedback loop to control the frequency of the output of an oscillator driving the system, so as to maintain a constant amplitude ratio or a constant phase relationship between the signals at those two points on the line.

The invention further provides a resistance meter for measuring the electrical resistance per unit length of an electrically conductive filament, which meter includes an electrically conductive structure through which coaxially passes an inner electrical conductor constituted by the filament, which meter also includes an oscillator for injecting an alternating electrical signal onto a transmission path comprising the structure and the filament passing through it, and measuring means for measuring a propagation constant of the injected signal, which meter is characterised in that the electrically conductive structure consists of an electrically conductive tube divided into a plurality of sections co-operating with the filament to constitute a coaxial transmission line, and in that said alternating electrical signal is injected onto the transmission line by an electrical connection between the oscillator and one of said sections.

Resistance meters embodying the invention in preferred forms are described below. This description is prefaced with a description of the underlying principles of operation with particular reference to transmission line theory.

Reference has already been made to Figures 1 to 5 of the accompanying drawings, in which:
Figure 1 is a diagram of apparatus suitable for making direct current resistance measurements,
Figure 2 is a diagram of apparatus which can in principle be used for making alternating current resistance measurements,
Figure 3 depicts the equivalent circuit for the apparatus of Figure 2, and
Figure 4 is a diagram of a variant of the apparatus of Figure 2,
Figure 5 depicts the equivalent circuit for the apparatus of Figure 4.

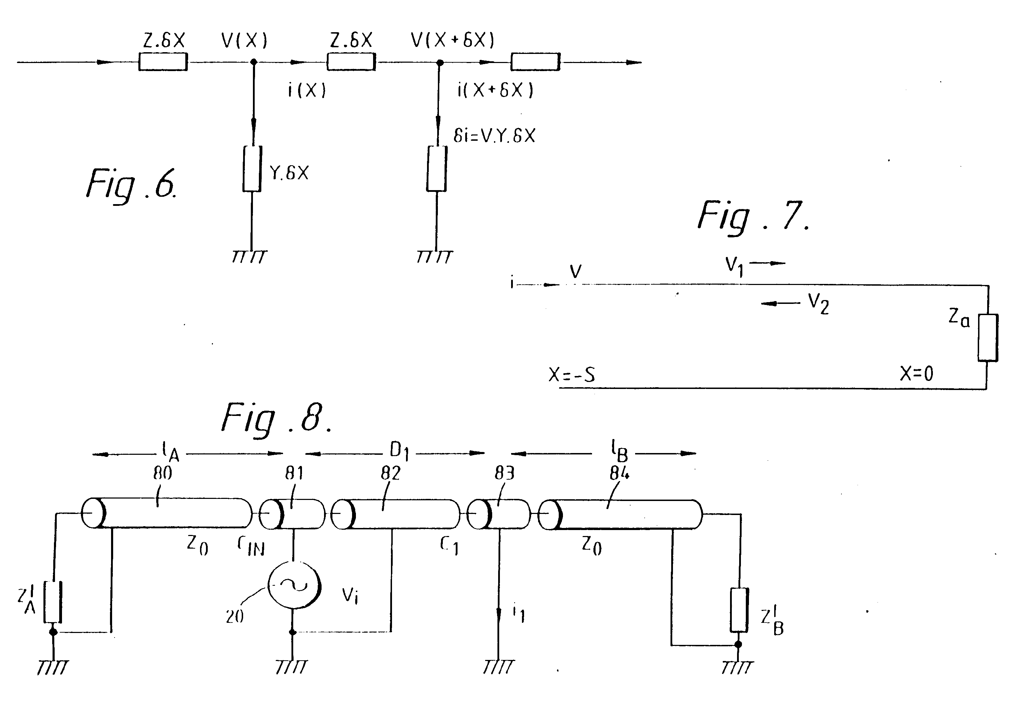

In the ensuing description, reference is additionally made to Figures 6 to 10 of the accompanying drawings, in which:
Figure 6 is an equivalent circuit of an infinitesimal length of transmission line,
Figure 7 is a diagram of a transmission line terminated with a lumped impedance,
Figure 8 is a diagram of a resistance meter which is a transmission line equivalent of the diagram of the meter of Figure 2,

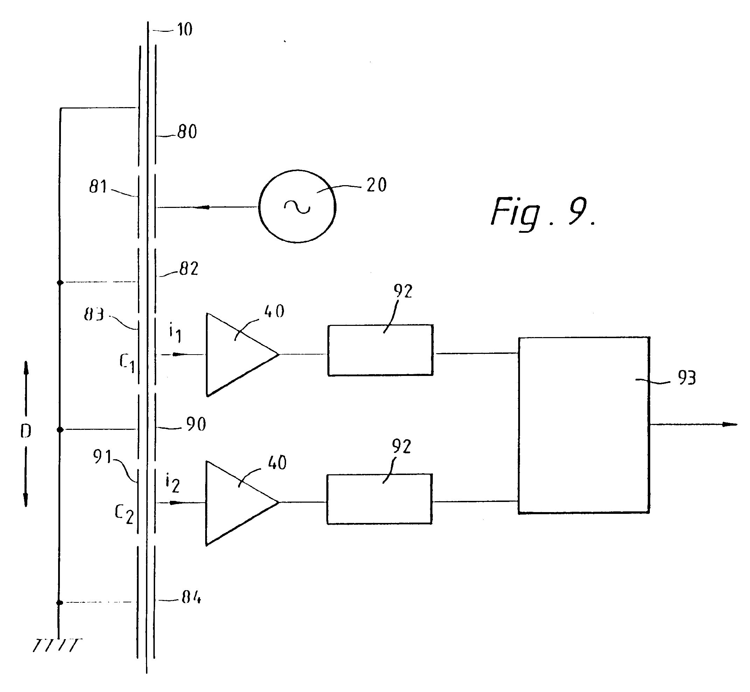

Figure 9 is a diagram of a resistance meter which is a transmission line equivalent of the meter of Figure 4, and

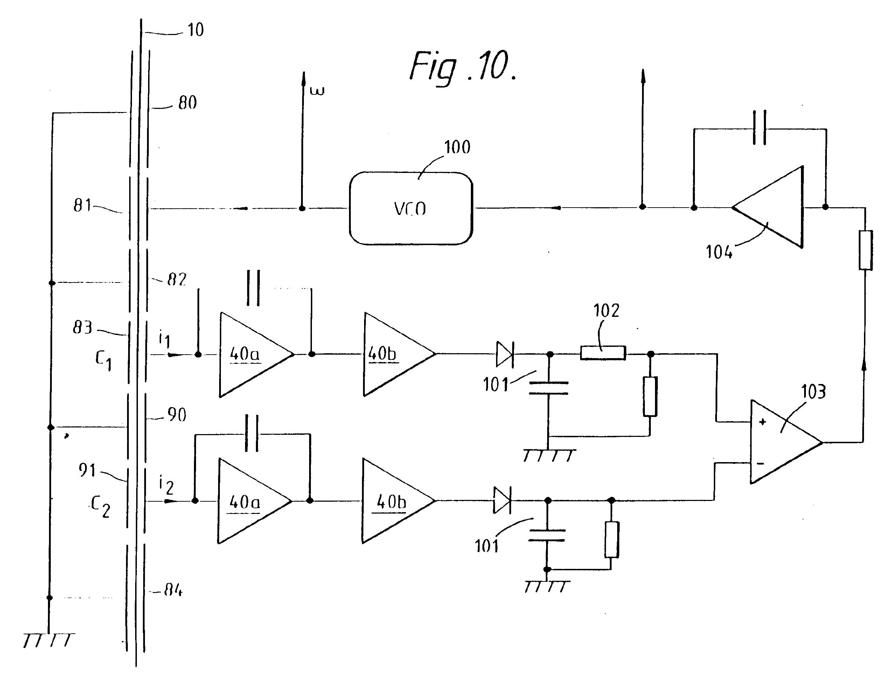

Figure 10 is a diagram of a modified form of the meter of Figure 9 incorporating a feedback loop to control the frequency of the signal injected on to its transmission line.

The capacitive coupling between the conductive coating on an optical fibre and its surroundings is distributed in nature, and hence propagation of an electrical signal along it is not accurately predicted by the lumped impedances shown in Figures 3 and 5. A more appropriate model treats the fibre as a lossy transmission line. The properties of a uniform transmission line are fully determined by the series inductance and resistance per unit length, and by the parallel capacitance and conductance per unit length. For the case of a cylindrical central conductor of radius a, surrounded by a coaxial second conductor or screen of radius b, these are as follows:
Series inductance per unit length$\text{L=} \frac{\text{»»₀}}{\text{2π}} \text{ln} \frac{\text{b}}{\text{a}}$
Parallel capacitance per unit length$\text{C=} \frac{\text{2πεε₀}}{\text{ln} \frac{\text{b}}{\text{a}}}$
Series resistance per unit length R
Parallel conductance per unit length G

In a non-contacting fibre conductivity measuring device, it will generally be required that the radius of the bore of the instrument, b, be substantially greater than the fibre radius, a. Because of the logarithmic variation of the impedances with size, the transmission line characteristics will, in such circumstances, be relatively insensitive to small changes in diameter. The behaviour of noncircular devices will be similar, with b approximately equal to the clearance between the fibre and the conducting walls of the device.

Consider a signal of angular frequency ω propagating down the transmission line.${\text{voltage v = v}}_{\text{o}} \text{exp j(ωt - kx)}$${\text{current i = i}}_{\text{o}} \text{exp j(ωt - kx)}$

For a lossy guide, the propagation constant, k, will be complex.$\text{k= β - j α}$
At angular frequency ω:
Series impendance per unit length$\text{Z=R+ jωL}$
Parallel admittance per unit length$\text{Y=G+jωC}$

For most cases of interest here, the parallel conductance, G, corresponding to a leaky or lossy dielectric, can be ignored. Figure 6 shows the series and parallel elements in an infinitesimal length δx of transmission line.

In the limit δx→0:$\frac{\text{dv}}{\text{dx}} \text{=-i·z}$$\frac{\text{di}}{\text{dx}} \text{=-v·Y}$

Eliminating i and v from the differential equations:$\text{-k²i=} \frac{\text{d²i}}{\text{dx²}} \text{=-Y} \frac{\text{dv}}{\text{dx}} \text{=iYZ}$$\text{-k²=RG-ω²LC+jω(RC+LG)}$

In the case of a lossless transmission line, R = G = O, in which case$\text{k=β=ω} \sqrt{\text{LC}}$

Under these circumstances the signals propagate with velocity$\text{u=} \frac{\text{ω}}{\text{β}} \text{=} \frac{\text{1}}{\sqrt{\text{LC}}}$ equal to the velocity of light in the dielectric between the conductors. In the present instance, it is desired to measure a finite series resistance per unit length, R, and it is generally valid to assume that G = O. It is convenient to define a quality factor, Q, equal to the ratio of the oscillatory and dissipative terms.$\text{Q=} \frac{\text{ω²LC}}{\text{ωRC}} \text{=} \frac{\text{ωL}}{\text{R}}$
so that$\text{k² = -jωRC(1+jQ)}$

For a 1251»m fibre in a 5mm bore conducting cylinder, b/a = 40, and assuming » = ε = 1,$\text{L = 0.74 »H m⁻¹}$$\text{C=15pFm⁻¹}$

The resistance of typical coatings is around 1M Ω m⁻¹, so Q = (7.4 x 10⁻¹³ω) is very much less than unity and, for all frequencies below 100 mHz, will be small even with fibre resistances as low as 1 k Ω/m. It follows that the real and imaginary parts of the propagation constant k are approximately equal.$\text{k=±(1-j)} \sqrt{\frac{\text{ωRC(1+jQ)}}{\text{2}}}$

At a frequency of 1MHz:$\text{α ≈ β ≈ 7m⁻¹}$

Over a distance of 1/a (≈ 14cm) the signal amplitude will decrease by a factor 1/e ≈ 0.37, and the phase will change by 1 radian. This contrasts with the lossless guide in which the phase change per unit length is only 0.02, corresponding to a wavelength of 300 m.

An important parameter in predicting the power coupled into or out of a transmission line is the characteristic impedance, Zₒ, defined as the ratio of the potential between the conductors, and the current flowing through them:$\text{Z₀=} \frac{\text{v}}{\text{i}} \text{=} \frac{\text{jk}}{\text{Y}} \text{=} \sqrt{\frac{\text{Z}}{\text{Y}}}$$\text{=±(1-j)} \sqrt{\frac{\text{R}}{\text{2ωC}}} \text{(1+jQ)}$

The signs of K and Zₒ are positive for waves travelling in the direction of increasing axial distance, x, and negative for waves in the opposite direction. Zₒ is the impedance presented at one end of an infinitely long transmission line, or of a transmission line terminated by an impedance equal to Zₒ

If a transmission line of finite length is unmatched at one end, then the impedance presented at the other end will depend on the terminating impedance, the length of the transmission line, and the frequency of operation. In the case of a finite length of coaxial transmission line constituted by a portion of carbon coated optical fibre, where that fibre threads a conducting tube, the terminating impedance will be determined by the shape and proximity of conducting metalwork around the fibre beyond the tube. If that terminating impedance is not a matching impedance, then power is reflected back from the impedance discontinuity, as shown in Figure 7.
Incident wave$\text{v₁ = A exp j(ωt - kx)}$$\text{i₁=} \frac{\text{v₁}}{\text{Z₀}}$
Reflected wave$\text{v₂=A′exp j(ωt + kx)}$$\text{i₂=-} \frac{\text{v₂}}{\text{Z₀}}$
At the terminating impedance (X = 0)${\text{Z}}_{\text{a}} \text{=} \frac{\text{v₁+v₂}}{\text{i₁-i₂}} \text{=} \frac{\text{A+A′}}{\text{A-A′}} \text{Z₀}$
Reflection coefficient$\text{ρ=} \frac{\text{A′}}{\text{A}} \text{=} \frac{{\text{Z}}_{\text{a}} \text{-Z₀}}{{\text{Z}}_{\text{a}} \text{+Z₀}}$

It will be noted from the above that when the terminating impedance Zₐ is a matching impedance, i.e. Zₐ = Zₒ, the reflection coefficient is zero.

At the input to the transmission line x = -s,$\text{Z₁=} \frac{\text{v}}{\text{i}} \text{=Z₀} \frac{{\text{e}}^{\text{jks}} {\text{+ρe}}^{\text{-jks}}}{{\text{e}}^{\text{jks}} {\text{-ρe}}^{\text{-jks}}}$

In a conventional low loss (high Q) transmission line, the amplitude of the factor ρe^{-2iks} can be almost unity, resulting in large variations in Zᵢ. However in the present instance, attention is not directed to low loss transmission lines, and it is possible to choose dimensions and operating frequency so that the reflected wave is severely attenuated. For αs >> 1 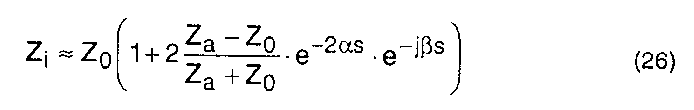
If αs >> 2, then variations in terminating impedance will produce less than +4% variation in Zᵢ under worst case conditions (open circuit or short circuit). Similarly, provided the measurement taps are arranged near the centre of a transmission line whose length is at least a few multiples of 1/α, any external noise at the measurement frequency will be severely attenuated.

Applying the foregoing considerations, Figure 8 is a diagram of an example of the basic single measurement tap type resistance meter of Figure 2 implemented in coaxial transmission line format. In this meter of Figure 8 the carbon coated optical fibre 10 threads five sections 80 to 84 of conductive tubing arranged in echelon. Each section 80 to 84 co-operates with the portion of fibre 10 threading it to form a length of transmission line of the same characteristic impedance, Zₒ. An alternating signal from oscillator 20 is applied to the system via section 81, and a portion of this signal is tapped from the system via section 783, and is fed to buffer amplifier 40. One end of section 81 terminates adjacent the end of section 80, and section 80 is made long enough in comparison with 1/α (typically > 2/α) to make it appear as a substantially matched termination for section 81 irrespective of the value of Z′_{A}, the stray impedance provided by coupling between the fibre and its surroundings beyond the end of section 80. Similarly section 84 is made long enough to make it appear as a substantially matched termination for section 83 irrespective of the value of Z′_{B}, the stray impedance provided by coupling between the fibre and its surroundings beyond the end of section 84. Finally, section 82 provides a matched impedance connection between sections 81 and 83. To prevent reflection from the measurement tap, section 83, its buffer amplifier 40 must have a low input impedance compared with the tap impedance. Alternatively compensation for the effect of finite amplifier input impedance is possible, for example by changing the dimensions of the coaxial transmission line conductor. However, it is difficult to ensure that such connections are stable and independent of frequency, and hence design of stable measuring equipment is simplified by the use of a low impedance buffer amplifier.

The tap impedance can be calculated from the current coupled into a grounded capacitive tap. Maintaining a constant impedance design to suppress reflections, it follows that for a tap extending from x₁ -w/2 to x₁ +w/2:

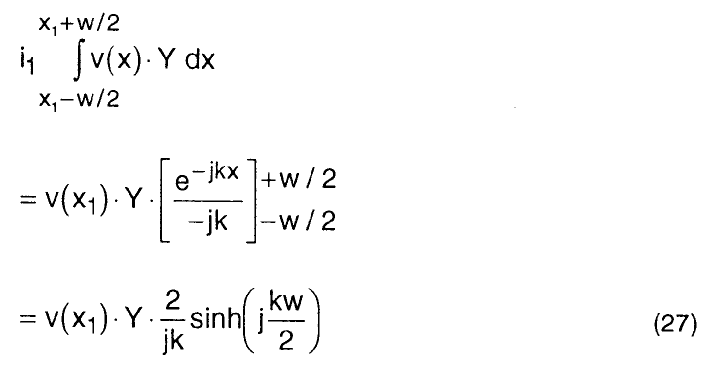

For electrodes that are short compared with the characteristic length, w << 1/α:$\text{i₁ ≈ V(x₁)·Y·w} \text{≈V(X₁)jωC.w}$

The tap acts as a pure capacitance of magnitude C1 = Cw connected to the central conductor. For longer taps, the current is equivalent to that induced in a short tap displaced towards the source of the transmitted signal. There is little advantage, in terms of coupled signal, in increasing the length of the tap beyond w = 1/a . It also follows that no particular problems are involved in choosing a tap length that will provide an impedance significantly greater than that achievable for a buffer amplifier constructed using conventional circuit design techniques.

Assuming that section 81 provides a coupling capacitance Cᵢₙ,
AC potential coupled onto fibre${\text{v}}_{\text{f}} {\text{=v}}_{\text{i}} \frac{{\text{jωC}}_{\text{in}} \text{Z₀}}{{\text{2+jωC}}_{\text{in}} \text{Z₀}}$

If now the length of section 82 is such as to space the measurement tap a distance D1 down the transmission line from the point of injection of the signal provided by oscillator 20, the voltage on the fibre will have decayed from v_{f} to V_{f1}, where${\text{v}}_{\text{f1}} {\text{=v}}_{\text{f}} \text{e} {\text{}}^{{\text{-jkD}}_{\text{1}}}$

Assuming that section 83 provides a coupling capacitance C₁, the signal current i₁ coupled out and fed to the buffer amplifier 40 is glven by${\text{i₁ = v}}_{\text{f1}} \text{jωC₁}$

Thus the transfer admittance$\frac{\text{i₁}}{\text{v₁}} \text{=-ω²} \frac{{\text{C₁C}}_{\text{in}} \text{Z₀}}{{\text{2+jωC}}_{\text{in}} \text{Z₀}} \text{e} {\text{}}^{{\text{-jβD}}_{\text{1}}} \text{·e} {\text{}}^{{\text{-αD}}_{\text{1}}}$

This shows that the coupling falls at low frequencies because the capacitative taps act as a high pass filter. At high frequencies, the attenuation term e^{-αD₁} dominates, and the signal again falls. This results in an ambiguous output at small values of the transfer admittance, although this may not be important if the conductance is restricted to a small range of values. Another disadvantage is that the output is very nonlinear because Z₀, α and β all depend on the fibre conductance, and are all functionally dependent upon the square root of R, the resistance per unit length of the carbon coated fibre.

The ambiguity in deducing the fibre conductance is resolved if two taps are used, as shown in Figure 9. This meter has the same components as the meter of Figure 8, but includes two additional sections 90, 91 of conductive tubing. Section 91 provides a second measurement tap, and is connected to a second buffer amplifier 40. Section 90 spaces section 91 from section 83. The two buffer amplifiers 40 are connected respectively to detectors 92, and the outputs of those detectors are fed to a logarithmic ratio unit 93. The ratio of tap currents is$\frac{\text{i₂}}{\text{i₁}} \text{=} \frac{\text{C₂}}{\text{C₁}} {\text{e}}^{\text{-jβD}} {\text{·e}}^{\text{-αD}}$
where D is the separation between the two taps. In respect of identical tap capacitances, C1 and C2, provided that termination effects are suppressed, the ratio depends only on the transmission line characteristics, the frequency, and the separation of the taps. The resistance per unit length of the coated fibre can be calculated from α via the amplitude ratio.

Provided that Q is very much smaller than unity, equations (4) and (13) give the relationship:
Fibre resistance per unit length

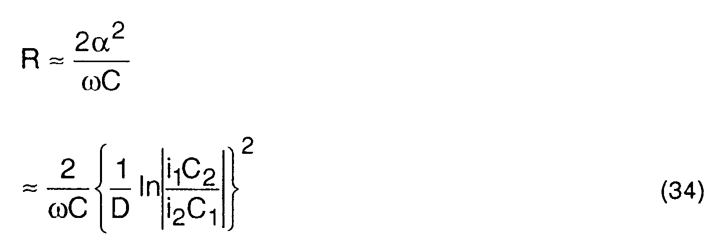

As an alternative to calculating the value of resistance per unit length of the fibre from a measure of α via the amplitude ratio, the same value can be calculated from a measure of β via the relative phases. For this purpose the two detectors 32 are replaced by limiters, and a phase meter is substituted for the logarithmic ratio unit 93.

In the foregoing analysis it is assumed implicitly that the oscillator frequency, ω, and the geometric configuration of the electrodes, both remain constant. This imposes limits on the accuracy attainable at both high and low values of the fibre resistance per unit length, R. For small R, the tap currents i₁ and i₂, are nearly equal, and small changes in their magnitude or relative phase will give large errors in the calculated value of R. Such changes may arise from lateral shifts in the fibre position, or from changes in stray capacitances, particularly if the transmission line sections 80 and 84 are not considerably longer than the electrode separation, D.

When R is large, i₂ will be very much smaller than i₁ due to the exponential variation of the tap current with separation D, and propagation constant. At first this will increase the susceptibility to errors from pick-up of the oscillator signal via stray capacitance, inadequate screening, or imperfect power supply decoupling. For very high fibre resistances, the tap signal will fall below the intrinsic noise in the tap amplifier.
The configuration shown in Figure 9 should be able to handle a 10:1 range of fibre conductance without resort to unusual measures to ensure accuracy and repeatability. If a greater dynamic range is required, then one option is to switch the oscillator frequency, giving more than one measurement range.

Figure 10 shows an alternative configuration in which the frequency is varied continuously to maintain a constant ratio between the tap currents i₁ and i₂. This meter has the same arrangement of seven sections of conductive tube as the meter of Figure 9. The oscillator 20 is replaced with a voltage controlled oscillator 100. The buffer amplifiers are constituted in this instance by two-stage amplifiers 40a and 40b.

Miller integrator amplifiers are preferred for the first stages since, with suitable commercially available integrated circuit amplifiers, this configuration has low noise and a low input impedance, which minimise the sensitivity to stray capacitances. Simple diode rectifier stages 101 receive the outputs of the second stages 60b. The rectifier stage for the first measurement tap includes an additional resistor 102 to form a potential divider bringing the value of its output to a level comparable with the output of the other rectifier stage. Precision rectifier stages or square law circuits may be used instead. The details are not critical since, as explained below, the voltage signal is independent of frequency to first order. It may be advantageous to operate both rectifiers at a similar drive voltage if a highly linear output is desired. In this case the potential divider would be omitted, and the gain of the voltage amplifier in the first channel would be reduced. A difference amplifier 103 produces an error signal proportional to (Pi₁ - i₂), where P is the ratio of the gains of the two tap amplifier channels. The error signal is integrated at 104, and used to control the frequency of the voltage controlled oscillator 100 which injects a high level ac signal into the fibre transmission line.

With appropriately chosen time constants, the frequency delivered by the voltage controlled oscillator 100 will track the fibre conductance. Similar results are possible using a phase comparator, but care is needed to avoid errors due to phase ambiguities. The circuit is a closed loop system which attempts to maintain a constant ratio i₁/i₂. The propagation constant, α and β are therefore constant.$\text{α²≈} \frac{\text{ωRC}}{\text{2}} \text{≈ constant}$$\text{Z₀≈(1-j)} \frac{\text{α}}{\text{ωC}}$

It follows that the voltage injected into the fibre is a constant fraction of the oscillator voltage, and that the voltage output from the miller integrator pre-amplifier 40a stages is also independent of frequency. Under conditions of practical interest, the stray impedances Z′_{A} and Z′_{B} are almost purely capacitive. Errors in the tap currents due to reflection from the ends of the transmission line depend on the ratio of the stray impedances to the characteristic impedance Z₀, and these ratios are independent of frequency.

The fibre conductance is given by:$\frac{\text{1}}{\text{R}} \text{=} \frac{\text{ωC}}{\text{2α²}}$
and is directly proportional to the frequency. C depends only on the ratio of the fibre diameter to the bore of the transmission line, with a small correction if the fibre has a dielectric coating such as an epoxyacrylate layer. To first order, stray capacitance will cause a change in the measured value of α which is independent of conductance and frequency. In order words, the scale factor may be different from that calculated from first principles, but will be constant throughout the measuring range.

In the case of a specific example of the meter of Figure 10 required to measure fibre conductance in the range 0.2 to 5x10⁻⁶Sm, i.e. fibre resistance between 5MΩm⁻¹ and 0.2MΩm⁻¹, and required to fit within a 50cm length on an optical fibre draw tower (not shown) a bore diameter of 5mm was chosen for the conductive tubing as a compromise between efficient coupling and a requirement for low sensitivity to lateral displacement of the 125»m diameter fibre. For 125»m fibre, this provides a calculated value of capacitance per unit length, C = 15pF m⁻¹. The chosen value for the ratio i₁/i₂ is e ≈ 2.7, so that D = 1. The lengths s of the transmission line sections 80 and 84 should satisfy 2αs>>1 for low sensitivity to stray capacitance. Choosing for a the value 12.5m⁻¹, D = 0.08m. This is achieved by making sections 83, 90 and 91 each 4 cm long. The tap capacitances C1 and C2 are therefore 0.6 pF. Sections 81 and 82 are also each 4cm long, enabling sections 80 and 84 both to be made 1 5cm long. For a fibre resistance of 1 MΩm⁻¹, the frequency output will be 1.6MHz. To cover the fibre conductance range 0.2 to 5x10⁻⁶Sm, the voltage controlled oscillator 100 has to sweep from 330kHz to 8.3MHz.

## Claims

1. A contactless method of measuring the electrical resistance per unit length of a filament(10), which filament is passed axially through an electrically conductive structure (80, 81, 82, 83, 84, 90, 91), wherein the method of measuring includes the measurement of a parameter functionally dependent upon a propagation constant of an alternating electrical signal injected onto a transmission path comprising the structure and the filament (10) passing through it, characterised in that the electrically conductive structure consists of an electrically conductive tube divided into a plurality of electrically discrete sections (80, 81, 82, 83, 84, 90, 91) co-operating with the filament (10) to constitute a coaxial transmission line, and in that said alternating electrical signal is injected onto one (81) of said sections.

2. A method as claimed in claim 1, wherein said measurement includes analysing the parameter of the signal that appears at one other (83) of said discrete sections as the result of said signal injection.

3. A method as claimed in claim 1, wherein said measurement includes comparing the relative amplitudes or phases of the signals that appear at two others (83, 91) of said discrete sections as the result of said signal injection.

4. A method as claimed in claim 3, wherein the comparison is employed in a feedback loop to control the frequency of the injected alternating signal.

5. A resistance meter for measuring the electrical resistance per unit length of an electrically conductive filament (10), which meter includes an electrically conductive structure (80, 81, 82, 83, 84, 90, 91) through which coaxially passes an inner electrical conductor constituted by the filament (10), which meter also includes an oscillator (20, 100) for injecting an alternating electrical signal onto a transmission path comprising the structure and the filament (10) passing through it, and measuring means for measuring a propagation constant of the injected signal, which meter is characterised in that the electrically conductive structure consists of an electrically conductive tube divided into a plurality of sections (80, 81, 82, 83, 84, 90, 91) co-operating with the filament (10) to constitute a coaxial transmission line, and in that said alternating electrical signal is injected onto the transmission line by an electrical connection between the oscillator (20, 100) one (81 ) of said sections.

6. A meter as claimed in claim 5, wherein the measuring means is connected to one other (83) of said sections.

7. A meter as claimed in claim 5, wherein the measuring means is connected to one other (83) of said sections and to a further one (91) of said sections, which measuring means (93) is adapted to compare the relative amplitudes or phases of the signals appearing at said one other section (83) and said one (91) of said further sections as the result of said signal injection.

8. A meter as claimed in claim 7, wherein the measuring means (93) has an output connected in a feedback loop path which is adapted to control the frequency of the oscillator (100).

9. A contactless method of determining the thickness of a coating applied to a filament (10), wherein the filament (10) is electrically insulating and of known diameter, and wherein the coating is an electrically conductive coating of known resistivity, in which method the thickness is derived from a measure of the resistance per unit length of the coated filament, which measure is made by the method as claimed in any claim of claims 1 to 4.

10. A method of determining the thickness of a coating applied to a filament (10), which method is as claimed in claim 9, and wherein the filament is an optical fibre.

## Patentansprüche

1. Verfahren zur kontaktlosen Messung des elektrischen Widerstandes pro Längeneinheit eines fadenförmigen Elementes (10), das in Axialrichtung durch eine elektrisch leitende Struktur (80,81,82,83,84,90,91) geführt wird, wobei das Meßverfahren die Messung eines Parameters einschließt, der funktionsmäßig von einer Ausbreitungskonstante eines elektrischen Wechselsignals abhängt, das auf einen Übertragungspfad injiziert wird, der die Struktur und das durch diese hindurchlaufende fadenförmige Element umfaßt,
dadurch gekennzeichnet, daß die elektrisch leitende Struktur aus einem elektrisch leitenden Rohr besteht, das in eine Mehrzahl von elektrisch getrennten Abschnitten (80,81,82,83,84,90,91) unterteilt ist, die mit dem fadenförmigen Element (10) zusammenwirken, um eine koaxiale Übertragungsleitung zu bilden, und daß das elektrische Wechselsignal auf einen (81) der Abschnitte injiziert wird.

2. Verfahren nach Anspruch 1, bei dem die Messung die Analyse des Parameters des Signals einschließt, das an einem anderen (83) der getrennten Abschnitte als Ergebnis der Signalinjektion auftritt.

3. Verfahren nach Anspruch 1, bei dem die Messung den Vergleich der relativen Amplituden oder Phasen der Signale einschließt, die an zwei anderen (83,91) der getrennten Abschnitte als Ergebnis der Signalinjektion auftreten.

4. Verfahren nach Anspruch 3, bei dem der Vergleich in einer Rückführungsschleife verwendet wird, um die Frequenz des injizierten Wechselsignals zu steuern.

5. Widerstandsmeßgerät zur Messung des elektrischen Widerstandes pro Längeneinheit eines elektrisch leitenden fadenförmigen Elementes (10), wobei das Meßgerät eine elektrisch leitende Struktur (80,81,82,83,84,90,91) einschließt, durch die ein innerer elektrischer Leiter, der durch das fadenförmige Element (10) gebildet ist, koaxial hindurchgeführt ist, wobei das Meßgerät weiterhin einen Oszillator (20,100) zur Injektion eines elektrischen Wechselsignals auf einen die Struktur und das durch diese hindurchlaufende fadenförmige Element (10) umfassenden Übertragungspfad und Meßeinrichtungen zur Messung einer Ausbreitungskonstante des injizierten Signals einschließt, wobei das Meßgerät dadurch gekennzeichnet ist, daß die elektrisch leitende Struktur aus einem elektrisch leitenden Rohr besteht, das in eine Mehrzahl von Abschnitten (80,81,82,83,84, 90,91) unterteilt ist, die mit dem fadenförmigen Element (10) zusammenwirken, um eine koaxiale Übertragungsleitung zu bilden, und daß das elektrische Wechselsignal auf die Übertragungsleitung über eine elektrische Verbindung zwischen dem Oszillator (20,100) und einem (81) der Abschnitte injiziert wird.

6. Meßgerät nach Anspruch 5, bei dem die Meßeinrichtung mit einem anderen (83) der Abschnitte verbunden ist.

7. Meßgerät nach Anspruch 5, bei dem die Meßeinrichtung mit einem anderen (83) der Abschnitte und einem weiteren (91) der Abschnitte verbunden ist, wobei diese Meßeinrichtung (93) so ausgebildet ist, daß sie die relativen Amplituden oder Phasen der Signale, die an dem einen anderen Abschnitt (85) und dem einen (91) der weiteren Abschitte als Ergebnis der Signalinjektion auftreten, vergleicht.

8. Meßgerät nach Anspruch 7, bei den die Meßeinrichtung (93) einen Ausgang aufweist, der in einem Rückführungsschleifenpfad geschaltet ist, der zur Steuerung der Frequenz des Oszillators (100) ausgebildet ist.

9. Kontaktloses Verfahren zur Bestimmung der Dicke einer auf ein fadenförmiges Element (10) aufgebrachten Beschichtung, bei dem das fadenförmige Element (10) elektrisch isolierend ist und einen bekannten Durchmesser aufweist, und bei dem die Beschichtung eine elektrisch leitende Beschichtung mit bekannten spezifischen Widerstand ist, wobei in diesem Verfahren die Dicke von einer Messung des Widerstandes pro Längeneinheit des beschichteten fadenförmigen Elementes abgeleitet wird und die Messung mit Hilfe des Verfahrens nach einem der Ansprüche 1 bis 4 erfolgt.

10. Verfahren zur Bestimmung der Dicke einer Beschichtung, die auf ein fadenförmiges Element (10) aufgebracht ist, wobei das Verfahren gemäß Anspruch 9 ausgebildet ist, und wobei das fadenförmige Element ein Lichtwellenleiter ist.

## Revendications

1. Procédé de mesure sans contact de la résistance électrique par unité de longueur d'un filament (10), ce filament passant axialement dans une structure conductrice de l'électricité (80, 81, 82, 83, 84, 90, 91), le procédé de mesure comprenant la mesure d'un paramètre qui dépend fonctionnellement d'une constante de propagation d'un signal électrique alternatif injecté dans un trajet de transmission comprenant la structure et le filament (10) passant dans la structure, caractérisé en ce que la structure conductrice de l'électricité est formée d'un tube conducteur divisé en plusieurs tronçons électriquement séparés (80, 81, 82, 83, 84, 90, 91) coopérant avec le filament (10) pour la constitution d'une ligne coaxiale de transmission, et en ce que le signal en courant alternatif est injecté dans l'un (81) des tronçons.

2. Procédé selon la revendication 1, dans lequel la mesure comprend l'analyse du paramètre du signal qui apparaît à un autre (83) des tronçons séparés à la suite de l'injection du signal.

3. Procédé selon la revendication 1, dans lequel la mesure comprend la comparaison des amplitudes ou phases relatives des signaux apparaissant à deux autres (83, 91) tronçons séparés à la suite de l'injection du signal.

4. Procédé selon la revendication 3, dans lequel la comparaison est utilisée dans une boucle à réaction négative pour le réglage de la fréquence du signal alternatif injecté.

5. Appareil de mesure de résistance destiné à mesurer la résistance électrique par unité de longueur d'un filament conducteur de l'électricité (10), l'appareil de mesure comprenant une structure conductrice de l'électricité (80, 81, 82, 83, 84, 90, 91) dans laquelle passe coaxialement un conducteur électrique interne constitué par le filament (10), l'appareil de mesure comprenant aussi un oscillateur (20, 100) destiné à injecter un signal en courant alternatif dans un trajet de transmission qui comprend la structure et le filament (10) passant dans celle-ci, et un dispositif de mesure d'une constante de propagation du signal à injecter, l'appareil de mesure étant caractérisé en ce que la structure conductrice de l'électricité est formée d'un tube conducteur de l'électricité divisé en plusieurs tronçons (80, 81, 82, 83, 84, 90, 91) coopérant avec le filament (10) pour la constitution d'une ligne coaxiale de transmission, et en ce que le signal électrique alternatif est injecté dans la ligne de transmission par une connexion électrique entre l'oscillateur (20, 100) et l'un (81) des tronçons.

6. Appareil de mesure selon la revendication 5, dans lequel le dispositif de mesure est connecté à un autre (83) des tronçons.

7. Appareil de mesure selon la revendication 5, dans lequel le dispositif de mesure est connecté à un autre (83) des tronçons et à un autre tronçon (91) supplémentaire, et le dispositif de mesure (93) est destiné à comparer les amplitudes ou phases relatives des signaux apparaissant à l'autre (83) des tronçons et à l'un (91) des tronçons supplémentaires à la suite de l'injection du signal.

8. Appareil de mesure selon la revendication 7, dans lequel le dispositif de mesure (93) a sa sortie connectée à un trajet formant une boucle à réaction négative qui est destiné à régler la fréquence de l'oscillateur (100).

9. Procédé de détermination sans contact de l'épaisseur d'un revêtement appliqué sur un filament (10), dans lequel le filament (10) est isolant de l'électricité et a un diamètre connu, et dans lequel le revêtement est un revêtement conducteur de l'électricité ayant une résistivité connue, l'épaisseur étant dérivée, dans ce procédé, d'une mesure de la résistance par unité de longueur du filament revêtu, cette mesure étant réalisée à l'aide du procédé selon l'une quelconque des revendications 1 à 4.

10. Procédé de détermination de l'épaisseur d'un revêtement appliqué sur un filament (10), selon la revendication 9, dans lequel le filament est une fibre optique.
